# EUROPEAN PATENT SPECIFICATION

(11) **EP 3 241 857 B1**
(45) Date of publication and mention of the grant of the patent: **06.05.2020**
(21) Application number: 15865344.4
(22) Date of filing: 30.11.2015
(51) Int. Cl.: C08G 59/40, B32B 7/02, B32B 27/38, C08K 5/3472, C08L 63/00, C08L 71/12, H05K 1/03, C08G 59/50, C08K 5/17, C08G 59/68, C09J 163/00

(54) **CURABLE RESIN COMPOSITION, MOLDED CURABLE-RESIN OBJECT, CURED OBJECT, LAYERED PRODUCT, COMPOSITE, AND MULTILAYERED PRINTED WIRING BOARD**
HÄRTBARE HARZZUSAMMENSETZUNG, FORMOBJEKT AUS HÄRTBAREM HARZ, GEHÄRTETES OBJEKT, SCHICHTPRODUKT, VERBUNDSTOFF UND MEHRSCHICHTIGE LEITERPLATTE
COMPOSITION DE RÉSINE DURCISSABLE, OBJET MOULÉ EN RÉSINE DURCISSABLE, OBJET DURCI, PRODUIT STRATIFIÉ, COMPOSITE ET CARTE À CIRCUIT IMPRIMÉ MULTICOUCHE

(30) Priority: 02.12.2014 JP 2014244349
(43) Date of publication of application: 08.11.2017
(73) Proprietor: Zeon Corporation, Tokyo 100-8246 (JP)
(72) Inventor: FUJIMURA, Makoto, Tokyo 100-8246 (JP); IGA, Takashi, Tokyo 100-8246 (JP)
(74) Representative: Viering, Jentschura & Partner mbB Patent- und Rechtsanwälte
(86) International application number: PCT/JP2015/005956
(87) International publication number: WO 2016/088358

(56) References cited:
- EP-A2- 0 960 725
- JP-A- 2002 105 672
- JP-A- 2002 105 672
- JP-A- 2002 110 595
- JP-A- 2002 110 595
- JP-A- 2008 274 311
- JP-A- 2009 221 320
- JP-A- 2009 287 080

## Description

### TECHNICAL FIELD

The present invention relates to a curable resin composition, molded curable resin object, cured object, layered product, composite, and multilayered printed wiring board.

### BACKGROUND ART

Recently, in pursuit of the miniaturization, multifunctionality, and increasing communication speed of electronic equipment, etc., a higher density printed substrate used for semiconductor elements in electronic equipment, etc. has been in demand. In order to meet such a demand, a printed substrate (hereinafter, referred to as a "multilayered printed wiring board") having a multilayered structure is used. Additionally, such a multilayered printed wiring board is, for example, formed by layering an electrical insulating layer on an inner layer substrate (including a core substrate obtained by forming an electrical insulating layer on both surfaces of a base material, as well as a conductor layer (wiring layer) formed on the surface of the core substrate), forming a conductor layer on this electrical insulating layer, then further sequentially forming an electrical insulating layer and a conductor layer on the inner layer substrate so as to obtain a substrate, and repeating, on the substrate, the layering of an electrical insulating layer and the formation of a conductor layer.

The electrical insulating layer of such a multilayered printed wiring board is required to have adhesiveness to conductor layers, along with favorable electrical properties, etc. This is because, if the adhesiveness between the electrical insulating layer and the conductor layer is weak, peeling may occur between these layers upon manufacturing or implementing the multilayered printed wiring board, and also upon use as a multilayered printed wiring board, etc., and may fail to sufficiently ensure reliability. This is also because, if the electrical properties are insufficient and the dielectric loss tangent of the electrical insulating layer is great, electric signals are significantly degraded, resulting in failure to sufficiently respond to the enhanced performance of the multilayered printed wiring board.

Here, until now, a cured object obtained by curing a curable resin composition has been used as the electrical insulating layer. Accordingly, as a curable resin composition capable of forming a cured object (electrical insulating layer) having excellent adhesiveness to conductor layers and electrical properties, an epoxy resin composition containing an epoxy resin, an active ester compound, and a triazine-containing cresol novolac resin is proposed (for example, see Patent Document 1). Additionally, according to the curable resin composition described in Patent Document 1, it is reported that an electrical insulating layer, which has a small dielectric loss tangent and may be favorably adhered to conductor layers, can be formed, with the electrical insulating layer having a small coefficient of linear expansion. Further examples of curable resin compositions are described in documents JP 2002 110595 A and JP 2002 105672 A.

### PRIOR ART DOCUMENTS

### Patent Documents

Patent Document 1: Japanese Unexamined Patent Application Publication No. 2011-132507

### SUMMARY OF THE INVENTION

### Problems to be Solved by the Invention

However, recently, the demand for enhanced performance of a multilayered printed wiring board has increased, necessitating that the properties of an electrical insulating layer (cured object) obtained by curing a curable resin composition be further improved. Under such circumstances, there is room for improvement in the abovementioned conventional curable resin composition, in that the adhesiveness of the obtained cured object to conductor layers particularly needs to be further improved.

Accordingly, an object of the present invention is to provide a curable resin composition capable of forming a cured object having excellent adhesiveness to conductor layers.

Another object of the present invention is to provide a molded curable resin object capable of forming a cured object having excellent adhesiveness to conductor layers.

Yet another object of the present invention is to provide a cured object having excellent adhesiveness to conductor layers, as well as a layered product, composite, and multilayered printed wiring board, which are formed using the cured object.

### MEANS FOR SOLVING THE PROBLEMS

The present inventors carried out extensive research in order to achieve the abovementioned purpose. Additionally, the present inventors found that when both a triazole compound and a tertiary amine compound having a specific structure are further added to a curable resin composition including an epoxy compound, a cured object having excellent adhesiveness to conductor layers can be formed, and this thereby led to the completion of the present invention.

That is, the present invention aims to advantageously resolve the abovementioned problems, with the curable resin composition according to the present invention including: an epoxy compound (A); a triazole compound (B); and a tertiary amine compound (C) represented by the following formula (I). 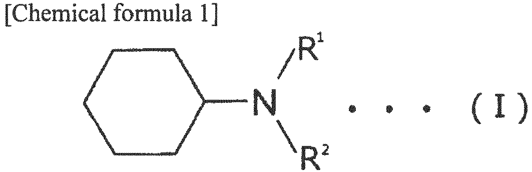 [In the formula, R¹ and R² each independently represent -(R³O)ₙH (wherein, R³ represents a C2-3 alkylene group and n is an integer of 1-3).]

In this manner, a cured object having excellent adhesiveness to conductor layers can be formed by curing a curable resin composition containing the epoxy compound (A), the triazole compound (B), and the tertiary amine compound (C) represented by the abovementioned formula (I).

Here, in the curable resin composition according to the present invention, the triazole compound (B) is an aminotriazole based compound represented by the following formula (II): 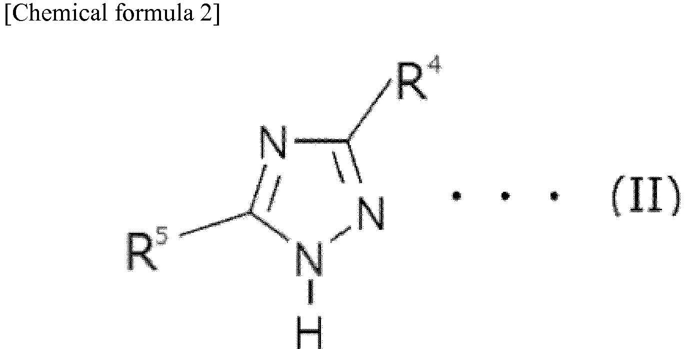 [In the formula, R⁴ and R⁵ each represent a hydrogen atom, a C1-6 alkyl group, a C1-6 alkylthio group, a benzylthio group, an ester group, a hydroxyl group, or -NR⁶R⁷ (wherein, R⁶ and R⁷ each independently represent a hydrogen atom, a C1-6 alkyl group, or a pyridyl group), and at least one of R⁴ and R⁵ represents -NR⁶R⁷]
or is represented by the following formula (III). 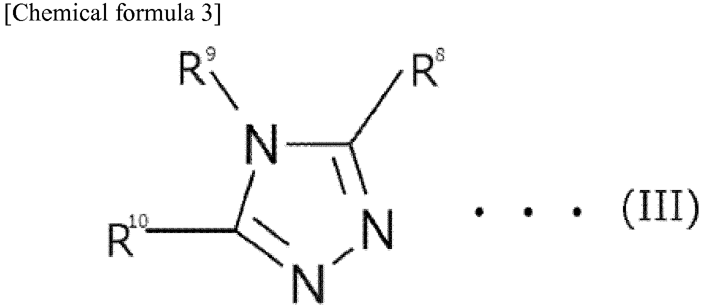 [In the formula, R⁸, R⁹, and R¹⁰ each represent a hydrogen atom, a C1-6 alkyl group, a C1-6 alkylthio group, a benzylthio group, an ester group, a hydroxyl group, or -NR⁶R⁷ (wherein, R⁶ and R⁷ each independently represent a hydrogen atom, a C1-6 alkyl group, or a pyridyl group), and at least one of R⁸, R⁹, and R¹⁰ represents -NR⁶R⁷.]

This is because by using, as the triazole compound (B), an aminotraizole based compound represented by the abovementioned formula (II) or (III), the adhesiveness of the cured object to conductor layers can be improved.

Additionally, in the curable resin composition according to the present invention, the proportion of the content of the tertiary amine compound to the total of the content of the triazole compound (B) and the content of the tertiary amine compound (C) is preferably 20 mass% to 80 mass%. This is because, if the content of the triazole compound (B) and the tertiary amine compound (C) satisfies the abovementioned relationship, the adhesiveness of the cured object to conductor layers can be enhanced.

Moreover, the curable resin composition according to the present invention preferably further includes an active ester compound. This is because, if it includes the active ester compound, curing of the curable resin composition can be favorably promoted, allowing the cured object to be easily formed, the adhesiveness of the cured object to conductor layers to be enhanced, and the dielectric loss tangent to be reduced.

In addition, the curable resin composition according to the present invention preferably further includes a polyphenylene ether compound.

Moreover, the present invention aims to advantageously resolve the abovementioned problems, and the molded curable resin object according to the present invention is formed using any of the abovementioned curable resin compositions. If a molded curable resin object formed from any of the abovementioned curable resin compositions is used, a cured object having excellent adhesiveness to conductor layers can be formed.

Further, the present invention aims to advantageously resolve the abovementioned problems, and the cured object according to the present invention is obtained by curing the abovementioned molded curable resin object. The cured object obtained by curing the abovementioned molded curable resin object has excellent adhesiveness to conductor layers.

Here, in the cured object according to the present invention, the dielectric loss tangent at a frequency of 5 GHz is preferably 0.010 or less. This is because, if the cured object, in which the dielectric loss tangent at a frequency of 5 GHz is 0.010 or less, is used to form the electrical insulating layer, a multilayered printed wiring board having enhanced performance can be produced which may suppress the transmission loss of electric signals.

Note that in the present invention, "the dielectric loss tangent at a frequency of 5 GHz" can be measured using a cavity resonator perturbation method.

Additionally, upon using the abovementioned cured object, a layered product obtained by layering the cured object and a base material, a composite obtained by forming a conductor layer on the surface on the cured object side of the layered product, and a multilayered printed wiring board formed using the composite can be suitably formed.

### EFFECTS OF THE INVENTION

The present invention can provide a curable resin composition capable of forming a cured object having excellent adhesiveness to conductor layers.

Moreover, the present invention can provide a molded curable resin object capable of forming a cured object having excellent adhesiveness to conductor layers.

Further, the present invention can provide a cured object having excellent adhesiveness to conductor layers, as well as a layered product, composite, and multilayered printed wiring board, which are formed using the cured object.

### MODE FOR CARRYING OUT THE INVENTION

Hereinafter, the embodiments according to the present invention will be described in detail.

Here, the curable resin composition according to the present invention is a resin composition that can be cured by heating, etc., and used to produce the molded curable resin object according to the present invention. Moreover, the molded curable resin object according to the present invention formed using the curable resin composition according to the present invention can be used to produce the cured object according to the present invention that may be suitably used as an electrical insulating layer, and the like. Additionally, the cured object according to the present invention can be suitably used to produce a layered product obtained by layering the cured object and a base material, a composite obtained by forming a conductor layer on the surface on the cured object side of the layered product, and a multilayered printed wiring board formed using the composite.

### (Curable resin composition)

The curable resin composition according to the present invention includes the epoxy compound (A), the triazole compound (B), and the tertiary amine compound (C). Note that the curable resin composition according to the present invention may contain, in addition to the abovementioned components, an active ester compound, a polyphenylene ether compound, a solvent, and other additives that are generally blended in a resin composition used upon forming an electrical insulating layer.

### <Epoxy compound (A)>

While not particularly limited thereto, examples of the epoxy compound (A) include a compound having two or more epoxy groups per one molecule, for example, an epoxy compound having an alicyclic olefin structure, an epoxy compound having a fluorene structure, a phenol novolac type epoxy compound, a cresol novolac type epoxy compound, a creosol type epoxy compound, a bisphenol A type epoxy compound, a bisphenol F type epoxy compound, a bisphenol S type epoxy compound, a bisphenol AF type epoxy compound, a polyphenol type epoxy compound, a brominated bisphenol A type epoxy compound, a brominated bisphenol F type epoxy compound, a hydrogenated bisphenol A type epoxy compound, an alicyclic epoxy compound, a glycidyl ester type epoxy compound, a glycidyl amine type epoxy compound, a tert-butyl-catechol type epoxy compound, a naphthol type epoxy compound, a naphthalene type epoxy compound, a naphthylene ether type epoxy compound, a biphenyl type epoxy compound, an anthracene type epoxy compound, a linear aliphatic epoxy compound, an epoxy compound having a butadiene structure, a heterocyclic epoxy compound, a spiro ring containing epoxy compound, a cyclohexane dimethanol type epoxy compound, a trimethylol type epoxy compound, and the like. These can be used alone or two or more thereof can be used in combination.

Among these, from the perspective of obtaining favorable mechanical properties and heat resistance of a curable resin composition, a molded curable resin object using the curable resin composition, and a cured object obtained by curing the molded curable resin object, and the like, the epoxy compound (A) is preferably an epoxy compound having two or more glycidyl groups, and more preferably a biphenyl type epoxy compound and an epoxy compound having an alicyclic olefin structure. Moreover, from the perspective of obtaining more favorable electrical properties and heat resistance of the cured object, a mixture of an epoxy compound having an alicyclic olefin structure or a biphenyl type epoxy compound and a polyfunctional epoxy compound having three or more epoxy groups per one molecule is particularly preferably used as the epoxy compound (A).

Note that while not particularly limited thereto, examples of an epoxy compound having an alicyclic olefin structure include an epoxy compound having a dicyclopentadiene skeleton. Additionally, examples of an epoxy compound having a dicyclopentadiene skeleton include trade names "Epiclon HP7200L," "Epiclon HP7200," "Epiclon HP7200H," "Epiclon HP7200HH," and "Epiclon HP7200HHH" (all produced by DIC Corporation); trade name "Tactix558" (produced by Huntsman Advanced Materials); and trade names "XD-1000-1L" and "XD-1000-2L" (all produced by Nippon Kayaku Co., Ltd.).

Moreover, exemplary biphenyl type epoxy compounds include trade names "NC-3000H," "NC-3000L," "NC-3000," and "NC-3100" (all produced by Nippon Kayaku Co., Ltd.); and trade names "YX4000," "YX4000H," "YX4000HK," and "YL6121" (all produced by Mitsubishi Chemical Corporation).

Further, exemplary polyfunctional epoxy compounds include trade names "1031S," "630," "604," and "1032 H60" (all produced by Mitsubishi Chemical Corporation).

### <Triazole compound (B)>

The triazole compound (B) used in the present invention is not particularly limited as long as it is a compound having a triazole ring (1,2,3-triazole ring, 1,2,4-triazole ring). If the curable resin composition includes both the triazole compound (B) and the below mentioned tertiary amine compound (C), the adhesiveness of the obtained cured object to conductor layers can be enhanced.

Here, examples of the triazole compound (B) include an aminotriazole based compound and a benzotriazole based compound, with the aminotriazole based compound being preferable. Note that the triazole compound (B) can be used alone, or two or more thereof can be used in combination.

### [Aminotriazole based compound]

The aminotriazole based compound is not particularly limited as long as it is a compound having a triazole ring and an amino group (excluding those configuring the triazole ring).

Exemplary aminotriazole based compounds include a compound represented by the following formula (II) or (III). 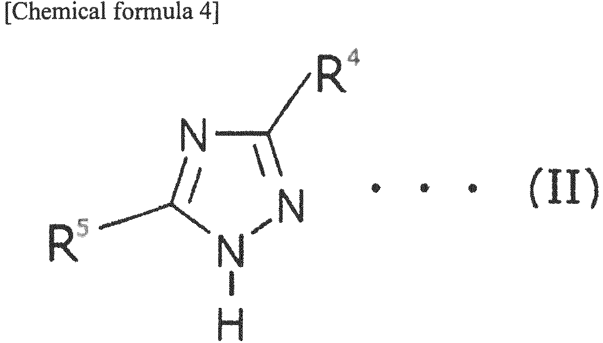 [In the formula, R⁴ and R⁵ each represent a hydrogen atom, a C1-6 alkyl group, a C1-6 alkylthio group, a benzylthio group, an ester group, a hydroxyl group, or -NR⁶R⁷ (wherein, R⁶ and R⁷ each independently represent a hydrogen atom, a C1-6 alkyl group, or a pyridyl group), and at least one of R⁴ and R⁵ represents -NR⁶R⁷.] 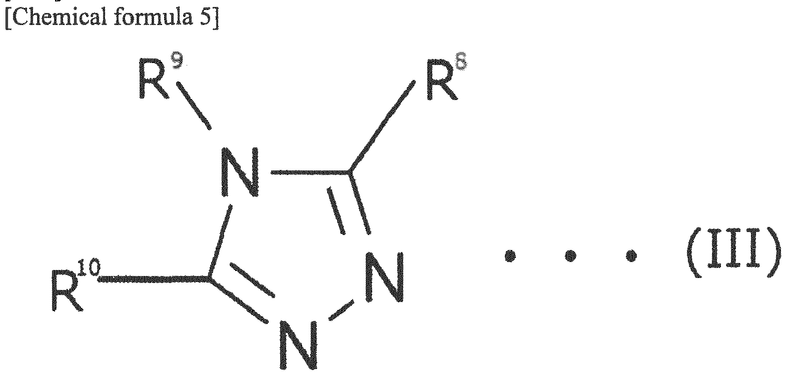 [In the formula, R⁸, R⁹, and R¹⁰ each represent a hydrogen atom, a C1-6 alkyl group, a C1-6 alkylthio group, a benzylthio group, an ester group, a hydroxyl group, or -NR⁶R⁷ (wherein R⁶ and R⁷ each independently represent a hydrogen atom, a C1-6 alkyl group, or a pyridyl group), and at least one of R⁸, R⁹, and R¹⁰ represents -NR⁶R⁷.]

### [Benzotriazole based compound]

The benzotriazole based compound is not particularly limited as long as it is a compound having a benzotriazole skeleton (provided that those having an amino group other than an amino group configuring a triazole ring are excluded), and for example, is preferably a compound represented by the following general formula (IV). 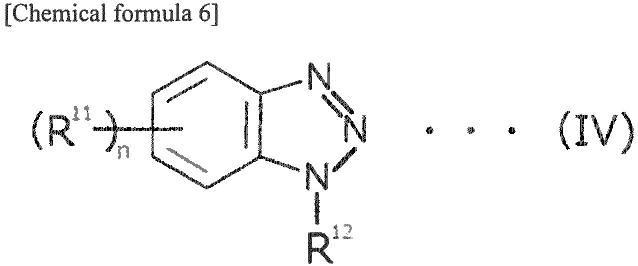 [In the formula, R¹¹ is a substituent group on a benzene ring representing a C1-6 alkyl group, a C1-6 alkoxy group, a C6-14 aryl group, a mercapto group, a C1-6 alkoxycarbonyl group, a C1-6 alkoxy group, or the like, and n is an integer of 0 to 4; wherein, if n is 2 or more, a quantity of n R¹¹ may be the same or different. Moreover, in the formula, R¹² represents a hydrogen atom, a CI-12 alkyl group, a C1-12 alkoxy group, a C6-14 aryl group, a mercapto group, a CI-12 alkoxycarbonyl group, a C1-12 alkoxy group, or the like.]

In the curable resin composition according to the present invention, the content of the triazole compound (B) per 100 parts by mass of the epoxy compound (A) is preferably 0.01 parts by mass or more, more preferably 0.03 parts by mass or more, further preferably 0.05 parts by mass or more, and preferably 13 parts by mass or less, more preferably 10 parts by mass or less, and further preferably 8 parts by mass or less. This is because, by making the content of the compound (B) per 100 parts by mass of the epoxy compound (A) to be 0.01 parts by mass or more, the adhesiveness of the cured object to conductor layers can be enhanced. This is also because, by making the content of the compound (B) per 100 parts by mass of the epoxy compound (A) to be 13 parts by mass or less, the reduction in heat resistance can be suppressed.

### <Tertiary amine compound (C)>

The curable resin composition according to the present invention must include a tertiary amine compound (C) represented by the following formula (I). 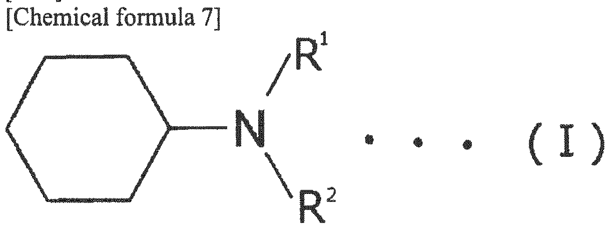 [In the formula, R¹ and R² each independently represent -(R³O)ₙH (wherein, R³ represents a C2-3 alkylene group and n is an integer of 1-3).]

Note that exemplary C2-3 alkylene groups include -CH₂(CH₃)-, -CH₂CH₂-, -CH₂CH₂CH₂-, -CH₂CH₂(CH₃)-, and -CH₂(CH₃)CH₂-.

Moreover, the tertiary amine compound (C) can be used alone or two or more thereof can be used in combination.

In the curable resin composition according to the present invention, the content of the tertiary amine compound (C) per 100 parts by mass of the epoxy compound (A) is preferably 0.01 parts by mass or more, more preferably 0.03 parts by mass or more, further preferably 0.05 parts by mass or more, and preferably 13 parts by mass or less, more preferably 10 parts by mass or less, and further preferably 8 parts by mass or less. This is because, by making the content of the compound (C) per 100 parts by mass of the epoxy compound (A) to be 0.01 parts by mass or more, the storage stability of the curable resin composition and the adhesiveness of the cured object to conductor layers can be enhanced. This is also because, by making the content of compound (C) per 100 parts by mass of epoxy compound (A) to be 13 parts by mass or less, the reduction in heat resistance can be suppressed.

Moreover, in the curable resin composition according to the present invention, the proportion of the content of the tertiary amine compound in the total of the content of the triazole compound (B) and the content of the tertiary amine compound (C) is preferably 20 mass% or more, more preferably 30 mass% or more, and preferably 80 mass% or less, and more preferably 70 mass% or less. By maintaining the proportion of compound (C) in the total of the compound (B) and the compound (C) within the abovementioned range, the adhesiveness of the cured object to conductor layers can be improved.

### <Active ester compound>

The curable resin composition according to the present invention preferably further includes an active ester compound. This is because the active ester compound may function as a curing agent for curing the curable resin composition, such that including the active ester compound in the curable resin composition allows curing to be favorably promoted, the cured object to be easily formed, the adhesiveness of the cured object to conductor layers to be enhanced, and the dielectric loss tangent to be reduced.

Here, as the active ester compound, a compound having an active ester group, which is a group having reactivity to the epoxy group of the epoxy compound (A), can be used. Additionally, as the active ester compound, a compound having at least two active ester groups per one molecule is preferably used. Note that the active ester group is an ester group that reacts with the -O-portion of a ring opened epoxy group upon reacting with the epoxy group, and does not form a hydroxyl group (-OH). More specifically, the active ester group is an ester group that generates an electron attractive group other than a proton (H+) upon reacting with an epoxy group.

Specifically, from the viewpoint of heat resistance, etc., the active ester compound is preferably an active ester compound, for example, obtained by carrying out a condensation reaction on a carboxylic compound and/or a thiocarboxylic compound with a hydroxy compound and/or thiol compound, more preferably an active ester compound obtained by reacting a carboxylic compound with one or more types selected from a group containing phenol compounds, naphthol compounds, and thiol compounds, and particularly preferably an aromatic compound that is obtained by reacting a carboxylic compound with an aromatic compound having a phenolic hydroxyl group, and the active ester compound has at least two active ester groups per one molecule. Note that examples of the carboxylic compounds, the thiocarboxylic compounds, the phenol compounds, the naphthol compounds, and the thiol compounds that may be used to prepare the active ester compound include compounds described in Japanese Unexamined Patent Application Publication No. 2011-132507.

Moreover, as the active ester compound, for example, active ester compounds disclosed in Japanese Unexamined Patent Application Publication No. 2002-12650 and Japanese Unexamined Patent Application Publication No. 2004-277460, or those commercially available can be used. Examples of commercially available active ester curing agents include those of trade names "EXB9451," "EXB9460," "EXB9460S," "HPC-8000-65T" (all produced by DIC Corporation), and the like.

In the curable resin composition according to the present invention, from the viewpoint of favorably promoting curing, the content of the active ester compound per 100 parts by mass of the epoxy compound (A) is preferably 10 parts by mass or more, more preferably 15 parts by mass or more, further preferably 20 parts by mass or more, and preferably 150 parts by mass or less, more preferably 130 parts by mass or less, and further preferably 120 parts by mass or less.

### <Solvent>

Moreover, the curable resin composition according to the present invention, if required, may include a solvent such as an organic solvent used upon preparing the curable resin composition, and the like.

### <Other additives>

Further, the curable resin composition according to the present invention, if required, may contain other additives such as inorganic fillers, curing accelerators, and polyphenylene ether compounds, in addition to the abovementioned components.

As an inorganic filler, inorganic fillers generally used in industrial applications can be used. Specifically, as an inorganic filler, for example, inorganic fillers described in Japanese Unexamined Patent Application Publication No. 2012-136646 can be used. Among these, because fine particles are easily obtained, silica is particularly preferable. Note that the inorganic filler may be one subjected to treatment with a silane coupling agent or treatment with an organic acid such as a stearic acid, but is preferably one subjected to treatment with a silane coupling agent from the viewpoint of dispersibility, water resistance, and the like.

Here, in the curable resin composition according to the present invention, the coefficient of linear expansion of the cured object can be lowered by blending an inorganic filler. Additionally, in the curable resin composition according to the present invention, from the viewpoint of sufficiently lowering the coefficient of linear expansion upon obtaining the cured object, the content ratio of the inorganic filler (in terms of solid content) is preferably 30 mass% or more, more preferably 45 mass% or more, further preferably 60 mass% or more, and preferably 90 mass% or less, more preferably 85 mass% or less, and further preferably 80 mass% or less.

While not particularly limited thereto, examples of a curing accelerator include aliphatic polyamine, aromatic polyamine, secondary amine, acid anhydride, imidazole derivatives, tetrazole derivatives, organic acid hydrazide, dicyandiamide and derivatives thereof, urea derivatives, etc., with imidazole derivatives particularly preferable among these. The content of the curing accelerator in the curable resin composition according to the present invention can be appropriately set in accordance with the content of the epoxy compound (A) and the active ester compound, for example.

Moreover, in addition to the abovementioned components, a polyphenylene ether compound may be further blended in the curable resin composition. By blending a polyphenylene ether compound, the heat resistance of a cured object (electrical insulating layer) formed using the curable resin composition can be enhanced, while the dielectric loss tangent can be reduced. Further, any additives such as a flame retardant, an auxiliary flame retardant, a heat resistant stabilizer, a weather resistant stabilizer, an aging inhibitor, an ultraviolet absorber (laser processing improving agent), a leveling agent, an antistatic agent, a slip agent, an antiblocking agent, an antifogging agent, a lubricant, a dye, a natural oil, a synthetic oil, a wax, an emulsion, a magnetic substance, a dielectric property adjustor, and a toughness agent may be blended in the curable resin composition in any blending amount.

### <Method for preparing the curable resin composition>

Additionally, while not particularly limited thereto, the abovementioned curable resin composition may be prepared by mixing each of the abovementioned components as is, prepared with each of the abovementioned components dissolved or dispersed in a solvent such as an organic solvent, or prepared by preparing a composition with a portion of each of the abovementioned components dissolved or dispersed in the solvent, then mixing the remaining components in the composition.

### (Molded curable resin object)

The molded curable resin object according to the present invention is obtained by molding the abovementioned curable resin composition according to the present invention in any shape such as a sheet shape or a film shape, for example. Additionally, while not particularly limited thereto, examples of the molded curable resin object according to the present invention include a film obtained by molding the curable resin composition according to the present invention into a sheet shape or a film shape, as well as a prepreg obtained in the form of a sheet shaped or film shaped molded composite object by impregnating the curable resin composition according to the present invention into a fiber base material.

Note that because the molded curable resin object according to the present invention is formed using the curable resin composition according to the present invention, a cured object having excellent adhesiveness to conductor layers can be formed.

### <Film>

Here, the film as a molded curable resin object according to the present invention can be formed by, if required, applying, onto a support, the curable resin composition according to the present invention with the solvent added thereto, and then, if required, drying the curable resin composition on the support. Additionally, the film obtained as described above is used while attached on the support or after being peeled off from the support.

Exemplary supports used to form the film include the resin film, metal foil, etc. described in WO 2012/090980.

Note that prior to peeling the support, for the case in which a via hole for electrically connecting conductor layers that are separate from each other in the layer direction is formed in the multilayered printed wiring board using laser processing, the support preferably has ultraviolet absorption. This is because, if the support has ultraviolet absorption, laser processing using an excimer laser, an UV laser, an UV-YAG laser, etc. is simplified. Further, this is because, if the support has ultraviolet absorption, even for a case in which ultraviolet rays are utilized after forming the hole to carry out a desmear treatment (desmearing of resin residues, etc. that arise), the ultraviolet rays are absorbed by the support, enabling roughening of the surface of the electrical insulating layer to be sufficiently suppressed.

Note that "having ultraviolet absorption" in the present invention means that the light transmittance at a wavelength of 355 nm measured using an ultraviolet/visible absorptiometer is 20% or less.

Moreover, exemplary methods for applying the curable resin composition include dip coating, roll coating, curtain coating, die coating, slit coating, gravure coating, and the like.

Further, the temperature upon drying the curable resin composition applied onto the support is preferably a temperature at which the curable resin composition according to the present invention is not cured, normally 20°C to 300°C, and preferably 30°C to 200°C If the drying temperature is too high, the curing reaction may be excessively promoted. Moreover, the drying period is normally 30 seconds to 1 hour, and preferably 1 minute to 30 minutes.

Note that while not particularly limited thereto, the thickness of the film is normally 1 µm to 150 µm, preferably 2 µm to 100 µm, and more preferably 5 µm to 80 µm from the viewpoint of workability, and the like.

Additionally, the film preferably has a curable resin composition in an uncured or semi-cured state. The term uncured used herein refers to the state in which substantially all epoxy compounds (A) are dissolved when the film is immersed in a solvent capable of dissolving the epoxy compound (A). Moreover, the term semi-cured used herein refers to the state in which the curable resin composition is halfway cured to the extent that it may be further cured when heated, preferably the state in which, when the film is immersed in a solvent capable of dissolving the epoxy compound (A), part of the epoxy compound (A) (specifically, 7 mass% or more) is dissolved, or the state in which the volume after immersing the film in the solvent for 24 hours is 200% or more of the volume prior to immersion.

Note that the film obtained using the curable resin composition according to the present invention may be a multiple-layer (multilayered) structure film having two layers or more. Specifically, the film may be a film used to manufacture a multilayered printed wiring board, etc., wherein the film has a two layer structure in which one layer is made of an adhesive layer adhered to the surface of the base material, while the other layer is made of a plated layer with a conductor layer formed on the surface.

### <Prepreg>

Moreover, a prepreg as the molded curable resin object according to the present invention can be formed by, if required, impregnating, into the fiber base material, the curable resin composition according to the present invention with the solvent added thereto, and then, if required, drying the curable resin composition.

Here, exemplary fiber base materials used to form the prepreg include organic fibers such as polyamide fibers, polyaramid fibers, and polyester fibers, along with inorganic fibers such as glass fibers and carbon fibers. Moreover, exemplary forms of the fiber base material include a woven cloth such as a plain weave or a twill weave, an unwoven cloth, and the like.

Moreover, while not particularly limited thereto, exemplary methods for impregnating the curable resin composition into the fiber base material include a method for immersing, in the fiber base material, the curable resin composition with the solvent added thereto in order to adjust the viscosity, etc., as well as a method for applying, to the fiber base material, the curable resin composition with the solvent added thereto, and the like. In the application method, the curable resin composition with the solvent added thereto can be applied to the fiber base material disposed on the support.

Here, the curable resin composition impregnated into the fiber base material can be dried as in the abovementioned film. Additionally, the prepreg, as in the abovementioned film, preferably contains the curable resin composition in an uncured or semi-cured state.

Note that while not particularly limited thereto, from the viewpoint of workability, and the like, the thickness of the prepreg is normally 1 to 150 µm, preferably 2 µm to 100 µm, and more preferably 5 µm to 80 µm. Moreover, the amount of the fiber base material in the prepreg is normally 20 mass% to 90 mass%, and preferably 30 mass% to 85 mass%.

### (Cured object)

The cured object according to the present invention can be obtained by carrying out a curing treatment on the molded curable resin object according to the present invention obtained via the abovementioned method. The curing treatment is normally a heating treatment on the molded curable resin object according to the present invention.

Note that because the cured object according to the present invention is formed by curing the molded curable resin object according to the present invention, it has excellent adhesiveness to conductor layers.

The curing temperature upon curing the molded curable resin object is normally 30°C to 400°C, preferably 70°C to 300°C, and more preferably 100°Cto 250°C. Moreover, the curing period is 0.1 hours to 5 hours, and preferably 0.5 hours to 3 hours. Additionally, the heating method is not particularly limited, and for example, may be carried out using an electric oven, or the like.

Here, from the viewpoint of producing a multilayered printed wiring board having enhanced performance, which may suppress the transmission loss of electric signals, in the cured object according to the present invention, the dielectric loss tangent at a frequency of 5 GHz is preferably 0.010 or less. Here, the dielectric loss tangent of the cured object can be adjusted, for example, by changing the constitution of the curable resin composition; wherein, the dielectric loss tangent of the cured object can be lowered, for example, by reducing the number of polar groups in the resin contained in the curable resin composition, or the like.

### (Layered product)

The layered product according to the present invention is obtained by layering the abovementioned cured object according to the present invention and the base material. Additionally, the layered product according to the present invention can be obtained, for example, by layering the abovementioned molded curable resin object of the present invention on the base material and curing the molded curable resin object on the base material.

Here, as the base material, for example, a substrate having a conductor layer on the surface can be used. A substrate having a conductor layer on the surface, for example, has a conductor layer on the surface of an electrical insulating substrate. The electrical insulating substrate is formed by curing a resin composition containing a known electrical insulating material (for example, an alicyclic olefin polymer, an epoxy resin, a maleimide resin, a (meth)acrylic resin, a diallyl phthalate resin, a triazine resin, a polyphenylene ether, glass, etc.). While not particularly limited thereto, the conductor layer is normally a layer including wiring formed by a conductive material such as a conductive metal and may further include various circuits. The configuration, thickness, etc. of wiring and circuits are not particularly limited. Specific examples of a substrate having a conductor layer on the surface may include a printed wiring substrate, a silicon wafer substrate, and the like. Additionally, the thickness of a substrate having a conductor layer on the surface is normally 10 µm to 10 mm, preferably 20 µm to 5 mm, and more preferably 30 µm to 2 mm.

Note that from the viewpoint of improving adhesiveness to the cured object obtained by curing the molded curable resin object according to the present invention, a substrate having a conductor layer on the surface may be subjected to pretreatment via a known method.

Here, exemplary known pretreatments include a treatment for applying a rust inhibitor onto the conductor layer in order to ensure adhesiveness between the conductor layer and the cured object. However, regarding cured objects obtained by forming the molded curable resin object according to the present invention, due to the contribution of the abovementioned triazole compound (B) and tertiary amine compound (C), even if the abovementioned treatment for applying the rust inhibitor is omitted, a sufficient adhesiveness improving effect can be obtained.

Moreover, by blending the triazole compound (B) and the tertiary amine compound (C) in the curable resin composition as in the present invention of the application, an excellent effect of improving adhesiveness is exerted compared with the case in which these are applied onto the conductor layer and used. While the reason for this is not clear, this is presumably because the strength (mechanical strength such as brittle fracture resistance and elastic modulus) of the obtained cured object is improved by blending these in the curable resin composition.

### (Composite and multilayered printed wiring board)

The composite according to the present invention includes a layered product according to the present invention, as well as a conductor layer formed on the surface of the cured object side in the layered product. Such a composite can be obtained by further forming a conductor layer on the surface of a layer (cured object) obtained by curing the molded curable resin object, via a metal plating and a metal foil, in the abovementioned layered product.

Additionally, the composite, for example, can be used for a multilayered printed wiring board. Specifically, after curing the molded curable resin object according to the present invention on a conductor layer formed on the surface on the cured object side in the layered product, so as to generate an electrical insulating layer, when a conductor layer is further formed in accordance with the method described in Japanese Unexamined Patent Application Publication No. 2012-136646, for example, the desired multilayered printed wiring board can be obtained.

The thus obtained composite according to the present invention, as well as the multilayered printed wiring board as one example of the composite according to the present invention, have an electrical insulating layer (cured object according to the present invention) obtained by curing the molded curable resin object according to the present invention, and the electrical insulating layer has excellent adhesiveness to conductor layers, allowing it to be used for various applications.

### EXAMPLES

Hereinafter, the present invention will be concretely described based on examples; however, the present invention is not limited to these examples. Note that "%"and "parts" representing amounts in the following descriptions refer to a mass standard unless otherwise noted.

In examples and comparative examples, the storage stability of the curable resin composition, dielectric loss tangent of the cured object, initial adhesiveness of the cured object to conductors, and adhesiveness thereof after high temperature/high humidity testing were evaluated using the following methods.

### <Storage stability>

The film of the curable resin composition (molded curable resin object) was stored at room temperature for six days. Subsequently, the abovementioned film after storage was layered on both surfaces of an inner layer circuit substrate (IPC MULTI-PURPOSE TEST BOARD No. IPC-B-25 pattern, conductor thickness: 30 µm, and substrate thickness: 0.8 mm) so as to abut the surface of the curable resin composition side. Primary pressing of the layering was carried out by heating and pressure bonding under a reduced pressure of 200 Pa at a temperature of 110°C and a pressure of 0.7 MPa for 30 seconds using a vacuum laminator including upper and lower heat resistant rubber pressing plates, and further, a hydraulic press device including upper and lower metal pressing plates was used for heating and pressure bonding at a pressure bonding temperature of 110°C at 1 MPa for 60 seconds. The support was peeled off from this layered product and curing was carried out at 180°C for 30 minutes. After curing, the maximum step difference between portions with a conductor of a comb type pattern portion with a conductor width of 165 µm and a conductor interval of 165 µm and portions without it was measured using a stylus step difference film thickness meter (P-10 produced by Tencor Instruments) and evaluated according to the following criteria. It is indicated that as the maximum step difference decreases, the wiring embedding planarity of the cured object obtained using the curable resin composition after storage is excellent, that is, the storage stability of the curable resin composition is excellent.
A: The maximum step difference is less than 4 µm.
B: The maximum step difference is 4 µm or more.

### <Dielectric loss tangent>

A small piece having a width of 2.6 mm, length of 80 mm, and thickness of 40 µm was cut out from the prepared film shaped cured object, and the dielectric loss tangent at 5 GHz was measured using a cavity resonator perturbation method dielectric constant measuring device.

### <Initial adhesiveness>

The surface of an electrolytic copper foil having a thickness of 35 µm was etched approximately 1 µm using an etchant (trade name "CZ-8101," produced by MEC Co., Ltd.). The film was layered such that the surface on the curable resin composition side of the film abutted the etching treatment surface of the obtained electrolytic copper foil, after which it was heated and pressure bonded under the conditions of a degree of vacuum of 1 kPa or less, 110°C, 30 seconds, and a pressure of 0.7 MPa using a vacuum laminator. Next, the support was peeled off from the surface opposing the surface of the curable resin composition side of the film, the surface of the curable resin composition that arose was overlapped with the etching treatment surface of a glass epoxy copper clad layer plate (FR-4) etched approximately 2 µm using the etchant, and heating and pressure bonding were carried out under the same conditions as above using a vacuum laminator. Subsequently, heating was carried out in an oven at 180°Cfor 30 minutes, then at 190°Cfor 90 minutes to obtain a composite sample. The tear-off strength (peel strength) of the copper foil from the obtained composite sample was measured in accordance with JIS C6481 and evaluated according to the following criteria.
A: Peel strength is 6.0 kN/m or more.
B: Peel strength is 5.5 kN/m or more, and less than 6.0 kN/m.
C: Peel strength is 5.0 kN/m or more, and less than 5.5 kN/m.
D: Peel strength is less than 5.0 kN/m.

### <Adhesiveness after high temperature/high humidity testing>

A sample obtained by peeling the copper foil of the portion other than a width of 10 mm of the remaining copper foil on the surface of the composite sample obtained as in the abovementioned "initial adhesiveness" was peeled, left to stand in a constant temperature/constant humidity bath having a temperature of 130°Cand a humidity of 85% RH for 100 hours, and the tear-off (peel strength) of the copper foil from this composite sample was measured in accordance with JIS C6481 and evaluated according to the following criteria.
A: Peel strength is 4.0 kN/m or more.
B: Peel strength is 3.5 kN/m or more, and less than 4.0 kN/m.
C: Peel strength is 3.0 kN/m or more, and less than 3.5 kN/m.
D: Peel strength is less than 3.0 kN/m.

### (Example 1)

### <Preparation of the curable resin composition>

One hundred parts of a biphenyldimethylene skeleton novolac type epoxy resin (trade name "NC-3000L," produced by Nippon Kayaku Co., Ltd., epoxy equivalent: 269) as the epoxy compound (A), 12.5 parts of a solution (1 part in terms of 3-amino-1H-1,2,4-triazole) with 8% 3-amino-1H-1,2,4-triazole (produced by Wako Pure Chemical Industries, Ltd., in formula (II), R⁴ corresponds to -NH2, and R⁵ corresponds to a compound that is H (hydrogen atom)) as the triazole compound (B) dissolved in ethanol, 1 part N,N-bis(2-hydroxyethyl)-N-cyclohexylamine (trade name "Wandamin (registered trademark) CHE-20P," produced by New Japan Chemical Co., Ltd., R¹ and R² in formula (I) correspond to a compound that is -CH₂CH₂OH) as the tertiary amine compound (C), 127.7 parts of an active ester compound (trade name "Epiclon HPC-8000-65T," a toluene solution having a nonvolatile content of 65%, produced by DIC Corporation, active ester group equivalent: 223) (83 parts in terms of an active ester compound), 351 parts silica (trade name "SC2500-SXJ," produced by Admatechs) as an inorganic filler, 1 part of a hindered phenol based antioxidant (trade name "Irganox (registered trademark) 3114," produced by BASF Corporation) as an aging inhibitor, and 110 parts anisole were mixed and stirred for 10 minutes using a planetary stirrer. Fifteen parts (3 parts in terms of 2-phenylimidazole) of a solution (trade name "Curezol (registered trademark) 2PZ," produced by Shikoku Chemicals Corporation) with 20% 2-phenylimidazole dissolved in ethanol as a curing accelerator were further mixed therein, and stirred for 5 minutes using a planetary stirrer to obtain a varnish of a curable resin composition. Note that in the varnish, the content of the filler was 65% in terms of solid content.

### <Manufacture of the film>

The varnish of the curable resin composition obtained above was applied using a die coater onto a polyethylene terephthalate film [support: Lumirror (registered trademark) T60 produced by Toray Industries, Inc.] having a length of 300 mm x width of 300 mm, a thickness of 38 µm, and a surface average roughness Ra of 0.08 µm, and then dried at 80°Cfor 10 minutes under a nitrogen atmosphere to obtain a film (molded curable resin object) of a curable resin composition having a thickness of 43 µm on the support. Additionally, using the obtained film, the storage stability, initial adhesiveness, and adhesiveness after the high temperature/high humidity testing were evaluated in accordance with the abovementioned methods. The results are shown in Table 1.

### <Manufacture of the film shaped cured object>

Subsequently, a small piece cut out from the obtained film was layered on a copper foil having a thickness of 10 µm, while fitted with the support, such that the film was disposed inside (copper foil side). Additionally, using a vacuum laminator including upper and lower heat resistant rubber pressing plates, the pressure of the layered product of a film with a support and the copper foil was reduced to 200 Pa, and the layered product was heated and pressure bonded at a temperature of 110°C and a pressure of 0.1 MPa for 60 seconds. Subsequently, the support was peeled off and heating and curing were carried out in air at 180°C for 30 minutes, then at 190°C for 90 minutes. After curing, a cured resin with a copper foil was cut out and the copper foil was dissolved in 1 mol/L of an ammonium persulfate aqueous solution to obtain a film shaped cured object. Using the obtained film shaped cured object, the dielectric loss tangent of the cured object was measured via the abovementioned method. The results are shown in Table 1.

### (Examples 2 to 5)

A curable resin composition, a film, and a film shaped cured object were manufactured as in Example 1, except that upon preparing the curable resin composition, the blending amounts of 3-amino-1H-1,2,4-triazole as the triazole compound (B), N,N-bis(2-hydroxyethyl)-N-cyclohexylamine as the tertiary amine compound (C), and an inorganic filler were changed as described in Table 1. Additionally, the same items as in Example 1 were evaluated. The results are shown in Table 1.

### (Example 6)

A curable resin composition was manufactured as in Example 2, except that upon preparing the curable resin composition, 167 parts of both a terminal styryl group modified polyphenylene ether compound (trade name "OPE-2St1200," produced by Mitsubishi Gas Chemical Company, Inc., a reaction product of 2,2',3,3',5,5'-hexamethylbiphenyl-4,4',-diol•2,6-dimethylphenol polycondensate and chloromethyl styrene, number average molecular weight (Mn)=1200, 60% toluene solution) (100 parts in terms of a polyphenylene ether compound) as a polyphenylene ether compound and 2 parts of a solution (1 part in terms of dicumyl peroxide) with 50% dicumyl peroxide (trade name "Perkadox BC-FF," produced by Kayaku Akzo Co., Ltd.) dissolved in toluene as a curing agent were further used, and the blending amount of the inorganic filler was changed to 535 parts.

Additionally, a film was manufactured as in Example 2, except that upon manufacturing the film, the polyethylene terephthalate film was changed to a polyethylene terephthalate film with a mold releasing agent applied thereto.

Further, a film shaped cured object was manufactured as in Example 2, except that upon manufacturing the film shaped cured object, the support was not peeled off, heating treatment was carried out at 180°C for 30 minutes, and the support was peeled, after which heating and curing were carried out in air at 190°C for 90 minutes.

Additionally, the same items as in Example 1 were evaluated. The results are shown in Table 1.

### (Comparative Example 1)

A curable resin composition, a film, and a film shaped cured object were manufactured as in Example 1, except that upon preparing the curable resin composition, the blending amount of 3-amino-1H-1,2,4-triazole as triazole compound (B) was changed to 13 parts, the tertiary amine compound (C) was not used, and the blending amount of the inorganic filler was changed to 371 parts. Additionally, the same items as in Example 1 were evaluated. The results are shown in Table 1.

### (Comparative Example 2)

A curable resin composition, a film, and a film shaped cured object were manufactured as in Example 1, except that when preparing the curable resin composition, the triazole compound (B) was not used, the blending amount of N,N-bis(2-hydroxyethyl)-N-cyclohexylamine as the tertiary amine compound (C) was changed to 13 parts, and the blending amount of the inorganic filler was changed to 371 parts. Additionally, the same items as in Example 1 were evaluated. The results are shown in Table 1.

### (Comparative Example 3)

### <Comparative Example 3-1>

A curable resin composition, a film, and a film shaped cured object were manufactured as in Example 1, except that neither the triazole compound (B) nor the tertiary amine compound (C) was used, and the blending amount of the inorganic filler was changed to 347 parts. Additionally, the same items as in Example 1 were evaluated. The results are shown in Table 1.

### <Comparative Example 3-2>

The curable resin composition of Comparative Example 3-1 was used to evaluate the adhesiveness when carrying out pretreatment of the triazole compound (B) and the tertiary amine compound (C) on a conductor layer. Specifically, upon evaluating the "initial adhesiveness" and "adhesiveness after high temperature/high humidity," treatment was carried out involving etching the surface of an electrolytic copper foil having a thickness of 35 µm by approximately 1 µm using an etchant (trade name "CZ-8101," produced by MEC Co., Ltd.), applying, onto the etching treated surface of the obtained electrolytic copper foil, a composition obtained by mixing 0.2 parts of 3-amino-1H-1,2,4-triazole as the triazole compound (B), 0.2 parts of N,N-bis(2-hydroxyethyl)-N-cyclohexylamine as the tertiary amine compound (C), and 50 parts of water, and drying at 100°Cfor 1 hour so as to manufacture a composite sample using the electrolytic copper foil, after which the peel strength was evaluated as in Example 1. The results are shown in Table 1.

**[Table 1]**

| | | | Example 1 | Example 2 | Example 3 | Example 4 | Example 5 | Example 6 | Comparative Example 1 | Comparative Example 2 | Comparative Example 3-1 | Comparative Example 3-2 |
|---|---|---|---|---|---|---|---|---|---|---|---|---|
| | Epoxy compound (A) | NC-3000L [parts by mass] | 100 | 100 | 100 | 100 | 100 | 100 | 100 | 100 | 100 | 100 |
| | Triazole compound (B) | 3-amino-1 H-1 2,4-triazole [parts by mass] | 1 | 2 | 3 | 1 | 7 | 2 | 13 | 0 | 0 | 0 |
| | Tertiary amine compound (C) | Wandamm CHE-20P [parts by mass] | 1 | 2 | 1 | 3 | 7 | 2 | 0 | 13 | 0 | 0 |
| | Active ester compound | HPC-8000-65T [parts by mass] | 83 | 83 | 83 | 83 | 83 | 83 | 83 | 83 | 83 | 83 |
| Curable resin composition | Polyphenylane ether compound | OPE-2St1200 [parts by mass] | 0 | 0 | 0 | 0 | 0 | 100 | 0 | 0 | 0 | 0 |
| | Curing agent | Perkadox BC-FF [parts by mass] | 0 | 0 | 0 | 0 | 0 | 1 | 0 | 0 | 0 | 0 |
| | Inorganic filler | SC2500-SXI [parts by mass] | 351 | 354 | 354 | 354 | 373 | 535 | 371 | 371 | 347 | 347 |
| | Aging inhibitor | Irganox 3114 [parts by mass] | 1 | 1 | 1 | 1 | 1 | 1 | 1 | 1 | 1 | 1 |
| | Curing accelerator | Curezol 2PZ [parts by mass] | 3 | 3 | 3 | 3 | 3 | 3 | 3 | 3 | 3 | 3 |
| | Inorganic filler content [wt%] | | 65 | 65 | 65 | 65 | 65 | 65 | 65 | 65 | 65 | 65 |
| Method for using (B) and (C) | | | Blending in the composition | Blending in the composition | Blending in the composition | Blending in the composition | Blending in the composition | Blending in the composition | Blending in the composition | Blending in the composition | Nonuse | Coated onto copper foil |
| Evaluation | Dielectric loss tangent [-] | | 0.005 | 0.005 | 0.005 | 0.005 | 0.005 | 0.004 | 0.005 | 0.005 | 0.005 | |
| | Storage stability | | A | A | A | A | A | A | B | A | A | |
| | Initial adhesiveness | | A | A | B | B | A | A | C | C | D | C |
| | Adhesiveness after high temperature/high humidity testing | | A | A | B | B | A | A | C | C | D | C |

The results of Table 1 indicate that the cured objects of Examples 1 to 6 have excellent adhesiveness to conductor layers. The results also indicate that the curable resin compositions of Examples 1 to 6 have excellent storage stability.

In contrast, the results of Comparative Example 1 indicate that the adhesiveness between the cured object and the conductor layer cannot be ensured, and the storage stability of the curable resin composition also cannot be ensured. Moreover, the results of Comparative Examples 2 and 3-1 indicate that the storage stability of the curable resin composition is excellent, while the adhesiveness between the cured object and the conductor layer cannot be ensured. Further, the results of Comparative Example 3-2 indicate that even if the pretreatment of applying the triazole compound (B) and the tertiary amine compound (C) onto the conductor layer is carried out, the adhesiveness between the cured object and the conductor layer is inferior compared to that of Examples 1 to 6.

### INDUSTRIAL APPLICABILITY

The present invention can provide a curable resin composition capable of forming a cured object having excellent adhesiveness to conductor layers.

Moreover, the present invention can provide a molded curable resin object capable of forming a cured object having excellent adhesiveness to conductor layers.

Further, the present invention can provide a cured object having excellent adhesiveness to conductor layers, as well as a layered product, composite, and multilayered printed wiring board, which are formed using the cured object.

## Claims

1. A curable resin composition, comprising: an epoxy compound (A); a triazole compound (B); and a tertiary amine compound (C) represented by the following formula (I): 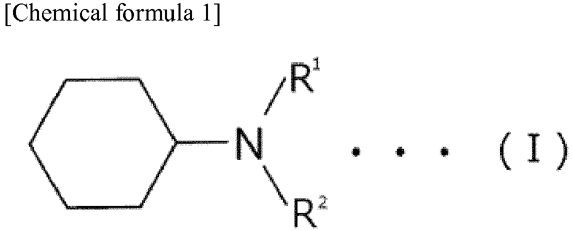 [in the formula, R¹ and R² each independently represent -(R³O)ₙH (wherein, R³ represents a C2-3 alkylene group and n is an integer of 1-3)],
wherein the triazole compound (B) is an aminotriazole based compound represented by the following formula (II): 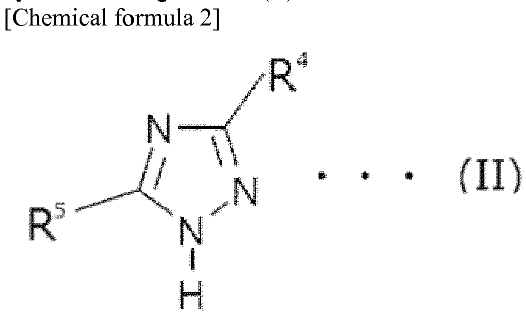 [in the formula, R⁴ and R⁵ each represent a hydrogen atom, a C1-6 alkyl group, a C1-6 alkylthio group, a benzylthio group, an ester group, a hydroxyl group, or -NR⁶R⁷ (wherein, R⁶ and R⁷ each independently represent a hydrogen atom, a C1-6 alkyl group, or a pyridyl group), and at least one of R⁴ and R⁵ represents -NR⁶R⁷]
or represented by the following formula (III): 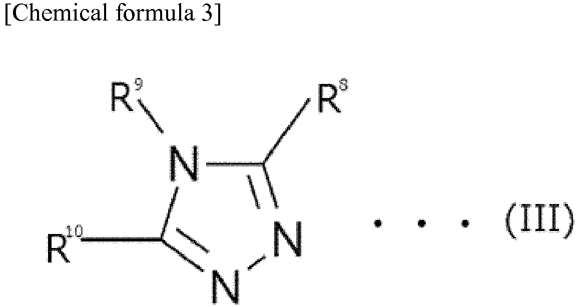 [in the formula, R⁸, R⁹, and R¹⁰ each represent a hydrogen atom, a C1-6 alkyl group, a C1-6 alkylthio group, a benzylthio group, an ester group, a hydroxyl group, or -NR⁶R⁷ (wherein, R⁶ and R⁷ each independently represent a hydrogen atom, a C1-6 alkyl group, or a pyridyl group), and at least one of R⁸, R⁹, and R¹⁰ represents -NR⁶R⁷].

2. The curable resin composition according to claim 1, wherein the proportion of the content of the tertiary amine compound in the total of the content of the triazole compound (B) and the content of the tertiary amine compound (C) is 20 mass% to 80 mass%.

3. The curable resin composition according to any of claims 1 to 2, further comprising an active ester compound.

4. The curable resin composition according to any of claims 1 to 3, further comprising a polyphenylene ether compound.

5. A molded curable resin object formed using the curable resin composition according to any of claims 1 to 4.

6. A cured object obtained by curing the molded curable resin object according to claim 5.

7. The cured object according to claim 6, wherein the dielectric loss tangent at a frequency of 5 GHz is 0.010 or less, wherein the dielectric loss tangent is measured using a cavity resonator perturbation method.

8. A layered product obtained by layering the cured object according to claim 6 or 7 and a base material.

9. A composite, comprising:
the layered product according to claim 8; and
a conductor layer formed on the surface on the cured object side of the layered product.

10. A multilayered printed wiring board formed using the composite according to claim 9.

## Patentansprüche

1. Härtbare Harzzusammensetzung aufweisend: eine Epoxyverbindung (A); eine Triazolverbindung (B) und eine tertiäre Aminverbindung (C), welche durch die folgende Formel (I) dargestellt ist: 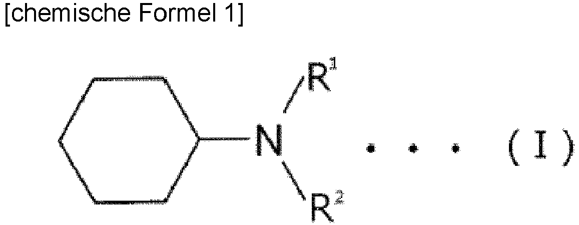 [in der Formel stellen R¹ und R² jeweils unabhängig voneinander -(R³O)ₙH dar (wobei R³ eine C2-3 Alkylengruppe darstellt und n eine ganze Zahl von 1-3 ist)], wobei die Triazolverbindung (B) eine Aminotriazol-basierte Verbindung ist, dargestellt durch die folgende Formel (II): 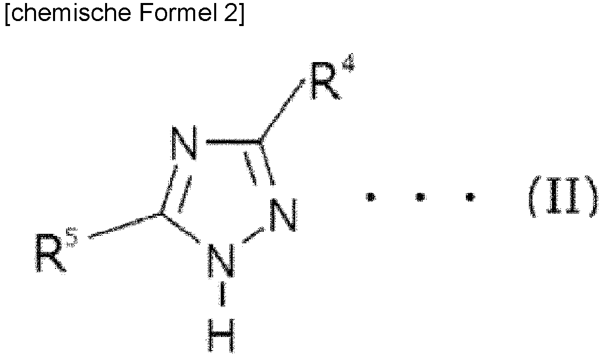 [in der Formel stellen R⁴ und R⁵ jeweils ein Wasserstoffatom, eine C1-6-Alkylgruppe, eine C1-6-Alkylthiogruppe, eine Benzylthiogruppe, eine Estergruppe, eine Hydroxylgruppe oder -NR⁶R⁷ dar (wobei R⁶ und R⁷ jeweils unabhängig voneinander ein Wasserstoffatom, eine C1-6-Alkylgruppe oder eine Pyridylgruppe darstellen), und wenigstens einer von R⁴ und R⁵ -NR⁶R⁷ darstellt]
oder dargestellt durch die folgende Formel (III): 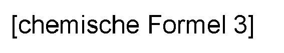 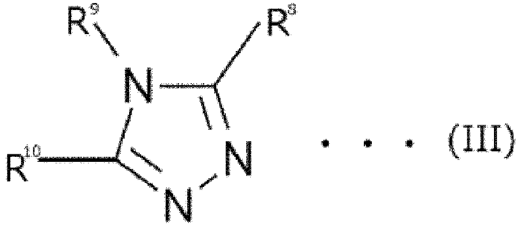 [in der Formel stellen R⁸, R⁹ und R¹⁰ jeweils ein Wasserstoffatom, eine C1-6-Alkylgruppe, eine C1-6-Alkylthiogruppe, eine Benzylthiogruppe, eine Estergruppe, eine Hydroxylgruppe oder -NR⁶R⁷ dar (wobei R⁶ und R⁷ jeweils unabhängig voneinander ein Wasserstoffatom, eine C1-6-Alkylgruppe oder eine Pyridylgruppe darstellen), und wenigstens einer von R⁸, R⁹ und R¹⁰ -NR⁶R⁷ darstellt].

2. Härtbare Harzzusammensetzung nach Anspruch 1, wobei der Anteil des Gehalts der tertiären Aminverbindung in der Gesamtsumme des Gehalts der Triazolverbindung (B) und des Gehalts der tertiären Aminverbindung (C) 20 Gew.-% bis 80 Gew.-% beträgt.

3. Härtbare Harzzusammensetzung nach irgendeinem der Ansprüche 1 bis 2, ferner aufweisend eine aktive Esterverbindung.

4. Härtbare Harzzusammensetzung nach irgendeinem der Ansprüche 1 bis 3, ferner aufweisend eine Polyphenylenetherverbindung.

5. Geformtes härtbares Harzobjekt, das unter Verwendung der härtbaren Harzzusammensetzung gemäß irgendeinem der Ansprüche 1 bis 4 gebildet ist.

6. Ausgehärtetes Objekt, erhalten durch Aushärten des geformten härtbaren Harzobjekts nach Anspruch 5.

7. Ausgehärtetes Objekt nach Anspruch 6, wobei der Tangens des dielektrischen Verlusts bei einer Frequenz von 5 GHz 0,010 oder weniger beträgt, wobei der Tangens des dielektrischen Verlusts unter Verwendung eines Hohlraumresonator-Störungsverfahrens gemessen wird.

8. Geschichtetes Produkt erhalten durch Schichten des gehärteten Objekts nach Anspruch 6 oder 7 und eines Grundmaterials.

9. Verbundstoff, aufweisend:
das geschichtete Produkt nach Anspruch 8; und
eine leitende Schicht, die auf der Oberfläche auf der Seite des gehärteten Objekts des geschichteten Produkts gebildet ist.

10. Mehrschichtige Leiterplatte, die unter Verwendung des Verbundstoffs nach Anspruch 9 gebildet ist.

## Revendications

1. Composition de résine durcissable comprenant : un composé époxy (A) ; un composé triazole (B) ; et un composé amine tertiaire (C) représenté par la formule (I) suivante : 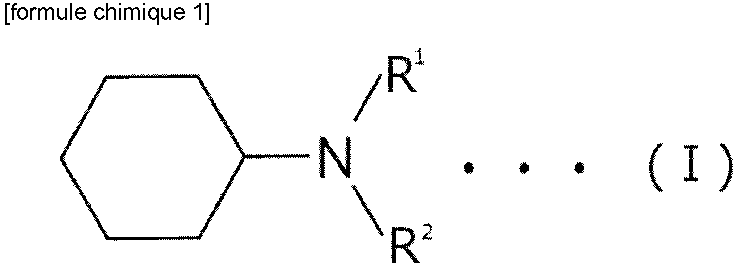 [dans la formule, chacun de R¹ et R² représente indépendamment -(R³O)ₙH (où R³ représente un groupe alkylène en C₂ à C₃ et n est un nombre entier de 1 à 3)],
dans laquelle le composé triazole (B) est un composé à base d'aminotriazole représenté par la formule (II) suivante : 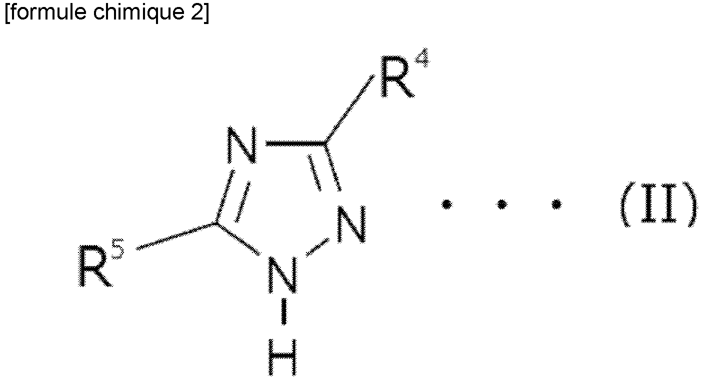 [dans la formule, chacun de R⁴ et R⁵ représente un atome d'hydrogène, un groupe alkyle en C₁ à C₆, un groupe alkylthio en C₁ à C₆, un groupe benzylthio, un groupe ester, un groupe hydroxyle, ou -NR⁶R⁷ (où chacun de R⁶ et R⁷ représente indépendamment un atome d'hydrogène, un groupe alkyle en C₁ à C₆, ou un groupe pyridyle), et au moins l'un de R⁴ et R⁵ représente -NR⁶R⁷]
ou représenté par la formule (III) suivante : 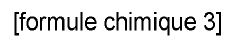 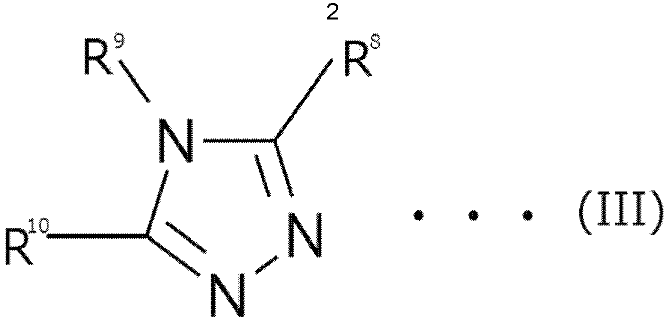 [dans la formule, chacun de R⁸, R⁹ et R¹⁰ représente un atome d'hydrogène, un groupe alkyle en C₁ à C₆, un groupe alkylthio en C₁ à C₆, un groupe benzylthio, un groupe ester, un groupe hydroxyle, ou -NR⁶R⁷ (où chacun de R⁶ et R⁷ représente indépendamment un atome d'hydrogène, un groupe alkyle en C₁ à C₆, ou un groupe pyridyle), et au moins l'un de R⁸, R⁹ et R¹⁰ représente -NR⁶R⁷].

2. Composition de résine durcissable selon la revendication 1, dans laquelle la proportion de la teneur du composé amine tertiaire dans le total de la teneur du composé triazole (B) et de la teneur du composé amine tertiaire (C) est de 20 % en masse à 80 % en masse.

3. Composition de résine durcissable selon l'une quelconque des revendications 1 et 2, comprenant en outre un composé ester actif.

4. Composition de résine durcissable selon l'une quelconque des revendications 1 à 3, comprenant en outre un composé polyphénylène-éther.

5. Objet en résine durcissable moulé formé par utilisation de la composition de résine durcissable de l'une quelconque des revendications 1 à 4.

6. Objet durci obtenu par durcissement de l'objet en résine durcissable moulé de la revendication 5.

7. Objet durci selon la revendication 6, dans lequel la tangente de perte diélectrique à une fréquence de 5 GHz est de 0,010 ou moins, dans lequel la tangente de perte diélectrique est mesurée par utilisation d'un procédé de perturbation avec un résonateur à cavité.

8. Produit stratifié obtenu par stratification de l'objet durci de la revendication 6 ou 7 et d'un matériau de base.

9. Composite comprenant :
le produit stratifié de la revendication 8 ; et
une couche de conducteur formée sur la surface du côté objet durci du produit stratifié.

10. Carte de circuit imprimé multicouche formée par utilisation du composite de la revendication 9.
